# EUROPEAN PATENT APPLICATION

(11) **EP 4 678 461 A1**
(43) Date of publication of application: **14.01.2026**
(21) Application number: 24917561.3
(22) Date of filing: 06.05.2024
(51) Int. Cl.: B60L 53/14, H04B 3/56

(54) **VEHICLE CHARGING APPARATUS AND METHOD**

(71) Applicant: Delta Electronics Inc., Taoyuan City 320023 (TW)
(72) Inventor: LIN, Bo-Song, Taoyuan City 320023, Taiwan (TW); KAO, Ming, Taoyuan City 320023, Taiwan (TW)
(74) Representative: Murgitroyd & Company
(86) International application number: PCT/CN2024/091156
(87) International publication number: WO 2025/231579

(57) **Abstract**

A vehicle charging device and a method applied to the device are disclosed. The device includes a transformer and two impedance tuners. One side of the transformer has two communication wires to couple with an electric vehicle. Each of the two impedance tuners is connected in parallel to one of the two communication wires. The two impedance tuners are configured to regulate reactance characteristics of the two communication wires. Therefore, the impedance of the communication wires can be gradually regulated in response to the signal strength, such that the vehicle charging device and the electric vehicle communicate in a state approaching impedance matching to prevent charging abnormalities caused by an excessively high bit error rate in data exchange.

## Description

### FIELD OF THE INVENTION

The present invention relates to the technical field of charging communication, particular to vehicle charging devices and methods.

### BACKGROUND OF THE INVENTION

With the increasing awareness of environmental protection, electric vehicles and related infrastructure are becoming increasingly widespread. During the vehicle charging process, an electric vehicle and a charging station can be coupled. After the electric vehicle and the charging station complete a charging communication operation, the charging station transmits power to the electric vehicle's batteries for charging.

During the charging communication operation, if the bit error rate of data exchange is too high, it may lead to abnormalities such as the inability to charge or charging interruptions in the electric vehicle. Although there have been some charging control technical solutions in the prior art, there is still room for improvement.

### SUMMARY OF THE INVENTION

An object of the present invention is to provide vehicle charging devices and methods to effectively improve the abnormal charging situation caused by poor communication quality.

To achieve the above-mentioned object, one aspect of the present invention provides a vehicle charging device, including: a transformer having a first side and a second side, the second side being provided with two communication wires to couple with an electric vehicle; and two impedance tuners, each of the two impedance tuners being connected in parallel to one of the two communication wires, and the two impedance tuners being configured to regulate reactance characteristics of the two communication wires.

To achieve the object mentioned above, one aspect of the present invention provides a vehicle charging method, applied to a vehicle charging device, the vehicle charging device including a transformer and two impedance tuners, the transformer having a first side and a second side, the second side having two communication wires to couple with an electric vehicle, each of the two impedance tuners being connected in parallel to one of the two communication wires, the two impedance tuners being configured to regulate reactance characteristics of the two communication wires, the method including: detecting the electric vehicle being coupled to two communication wires connected to the vehicle charging device; performing power line communication between the vehicle charging device and the electric vehicle to enable the vehicle charging device to collect signal strengths of a plurality of signal channels for the electric vehicle; monitoring, by the vehicle charging device, the communication characteristics of the two communication wires based on the signal strengths of the plurality of signal channels to enable signal strengths of the two communication wires to meet a strength requirement; and in response to the signal strengths of the two communication wires meet the strength requirement, performing a charging mode for the electric vehicle.

In the vehicle charging device and method of the present invention, the second side of the transformer of the vehicle charging device is provided with two communication wires (having capacitors) to couple the electric vehicle, and each impedance tuner of the vehicle charging device is connected in parallel to one communication wire. The two impedance tuners are configured to regulate the reactance characteristics of the two communication wires. For example, each of the two impedance tuners includes at least one branch path (including a switch and a capacitor), and each of at least one branch path is connected in parallel with the capacitor of the communication wire. Thus, in response to the signal strength of the communication wire, an appropriate number of branch path capacitors can be gradually controlled to connect to the capacitors of the communication wire to regulate the impedance of the communication wire such that the vehicle charging device and the electric vehicle can communicate with each other in a state approaching impedance matching, thereby avoiding abnormal situations such as the electric vehicle being unable to charge or charging being interrupted due to excessively high bit error rates in data exchange.

### BRIEF DESCRIPTION OF THE DRAWINGS

FIG. 1 is a schematic diagram illustrating a vehicle charging system suitable for an embodiment of the present invention.
FIG. 2 is a schematic diagram illustrating a first signal transmission mode of the vehicle charging system shown in FIG. 1.
FIG. 3 is a schematic diagram illustrating an overview of the power spectrum density distribution of communication wires of a first example for a charging station shown in FIG. 2.
FIG. 4 is a schematic diagram showing an overview of the power spectrum density distribution of communication wires of a second example for a charging station shown in FIG. 2.
FIG. 5 is a schematic diagram illustrating a second signal transmission mode of the vehicle charging system shown in FIG. 1.
FIGs. 6a and 6b are schematic diagrams illustrating an equivalent circuit and insertion loss of the first example of the charging station shown in FIG. 5.
FIGs. 7a and 7b are schematic diagrams illustrating an equivalent circuit and insertion loss of the second example of the charging station shown in FIG. 5.
FIG. 8 is a schematic diagram illustrating signal strengths of a plurality of signal channels obtained by several examples of the charging station shown in FIG. 1.
FIG. 9 is a block diagram illustrating a vehicle charging device of an embodiment of the present invention.
FIG. 10 is a schematic diagram illustrating a connection configuration of switches and capacitors in branch paths as shown in FIG. 9.
FIG. 11 is a schematic flowchart illustrating a vehicle charging method of an embodiment of the present invention.

Description of reference signs:
10, 20, 50, 90, 100: Vehicle charging system
11, 21, 51: Charging station
12, 22, 52, 9B, 10B: Electric vehicles
13, 211, 511: Controller
30, 40: PSD distribution profile curve example
91, 101, 212, 512: Transformer
92, 102: Impedance tuner
921, 1021: Branch paths
23, 53, 93, 103: Communication wires
513: Bandpass filter
60a, 70a: Equivalent circuit examples
60b, 70b: Insertion loss curve examples
80: Signal strength curve example
94, 104: First capacitor
95, 105: switch
96, 106: Second capacitor
9A, 10A: Vehicle charging device
9C: Network
9D: Cloud Computing Platform
110: Vehicle charging method example
111, 112, 113, 114, 115: Steps
SPI_TX+, SPI_TX-, SPI_RX+, SPI_RX-, TXOUT_P, TXOUT_N, RXIN_P,
RXIN_N: Signal wires
C1, C2, C3: Curves
CP: Control pilot wire
PE: Protective earth wire
CTL: Control terminal
CN1, CN2: Connection terminal
VD: Power supply terminal
VDD: DC power supply
GND: Ground terminal
R: Resistor
M1: Sampling point

### THE DETAILED DESCRIPTION OF PREFERRED EMBODIMENTS

To make the above and other purposes, features, and advantages of the present invention more obvious and understandable, the preferred embodiments of the present invention will be specifically cited below and described in detail with reference to the accompanying drawings.

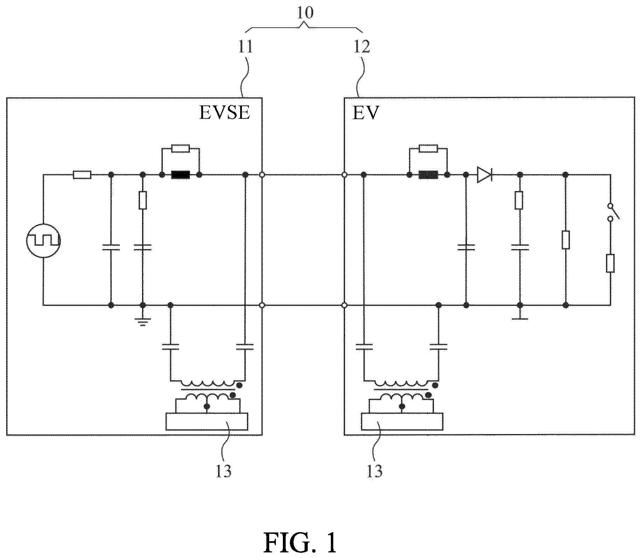

As shown in FIG. 1, in a vehicle charging system 10 (e.g., a combined charging system (CCS)), a charging station (Electric Vehicle Supply Equipment, EVSE) 11 and an electric vehicle (Electric Vehicle, EV) 12 can be coupled to each other. For example, the electric vehicle 12 includes vehicles such as motorcycles or cars. A charging gun of station 11 and a socket of the electric vehicle 12 form a coupler connection. After the electric vehicle 12 and the charging station 11 complete a charging communication operation, the charging station 11 transmits power to a battery of the electric vehicle 12 for charging. During a charging communication operation, if the controller 13 lacks an effective compatibility control or optimization mechanism, such as making regulation in response to the differences in couplers formed by different charging guns (such as different cable lengths or diameters), in a state of the coupler connection, if a bit error rate of data exchange is too high and there is a lack of adaptive compatibility in data communication, abnormal situations will occur, such as the inability to complete the charging communication operation, resulting in failure to charge or an interruption in charging to the electric vehicle, ultimately leading to a poor user experience.

For example, a power line communication (PLC) protocol is taken as an example. During the charging communication operation, a communication mode between the charging station and the electric vehicle may be a full duplex mode, allowing the charging station and the electric vehicle to perform bidirectional data transmission simultaneously.

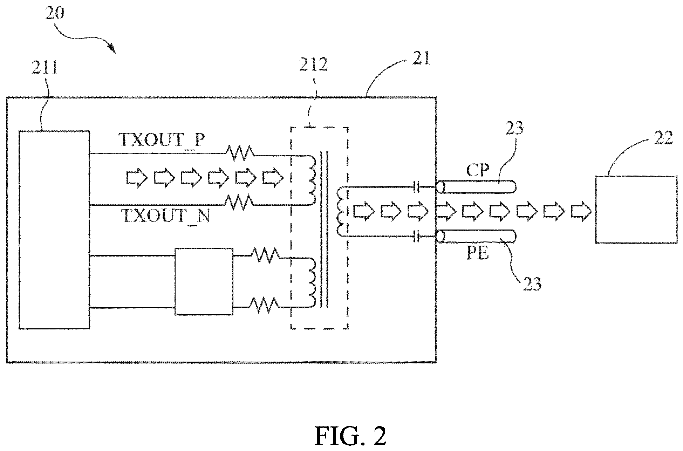

As shown in FIG. 2, in a first signal transmission mode, in a vehicle charging system 20, a controller 211 of a charging station 21 can utilize signal wires (such as TXOUT_P and TXOUT_N) to transmit signals passing the transformer 212 to an electric vehicle 22 via communication wires 23. For example, the communication wires 23 can be a control pilot wire (Control Pilot) CP and a protective earth wire (Protective Earth) PE. Meanwhile, signal attenuation will occur during the communication process if the impedance between the charging station 21 and the electric vehicle 22 does not match. For example, the charging station 21 may sweep the signal strengths of multiple signal channels between it and the electric vehicle 22 to obtain a specific signal's power-spectrum-density distribution profile (PSD profile).

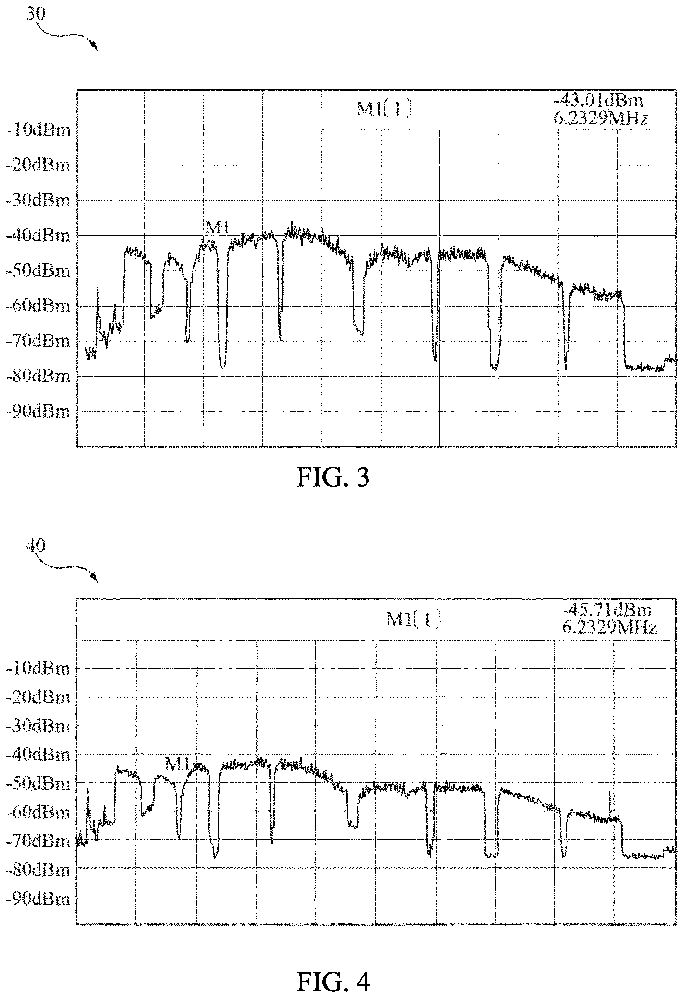

In an application example, FIG. 3 shows a PSD distribution profile curve example 30 of a communication wire (e.g., CP) obtained by a controller at a charging station via the ninth channel (CH9), in which signal strengths are mostly below -40 dBm. For example, the signal strength at a sampling point M1 is -43.01 dBm. In another application example, FIG. 4 shows a PSD distribution profile curve example 40 of a communication wire (e.g., CP) obtained by a controller of another charging station, in which all signal strengths are lower than -40 dBm. For example, the signal strength at the sampling point M1 is -45.71 dBm. FIGs. 3 and 4 show the signal strengths of the two charging stations differ by about 6 dB.

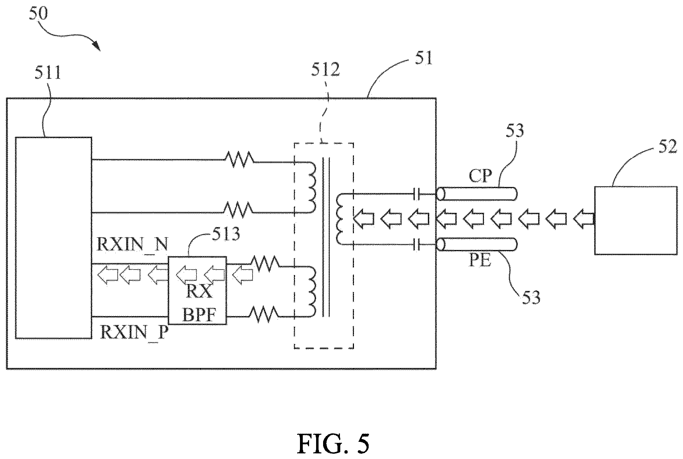

As shown in FIG. 5, in a second signal transmission mode, in a vehicle charging system 50, a controller 511 at a charging station 51 can use signal wires (e.g., RXIN_P and RXIN_N) to receive signals from the electric vehicle 52 via a communication wire 53 through a bandpass filter (RX_BPF) 513 and a transformer 512. For example, communication wires 53 can be a control pilot wire (CP) and a protective ground line (PE). Meanwhile, signal attenuation will occur during the communication process if the impedance between the charging station 51 and the electric vehicle 52 does not match.

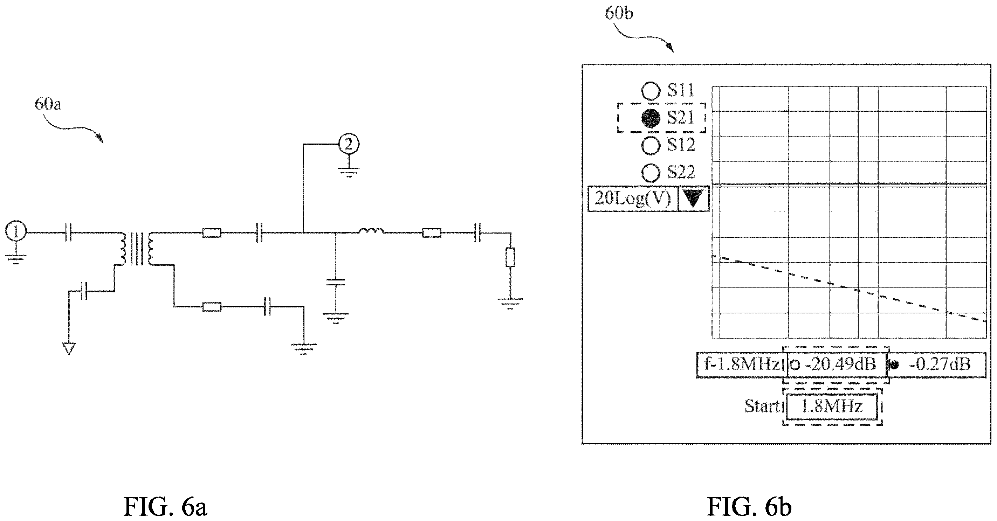

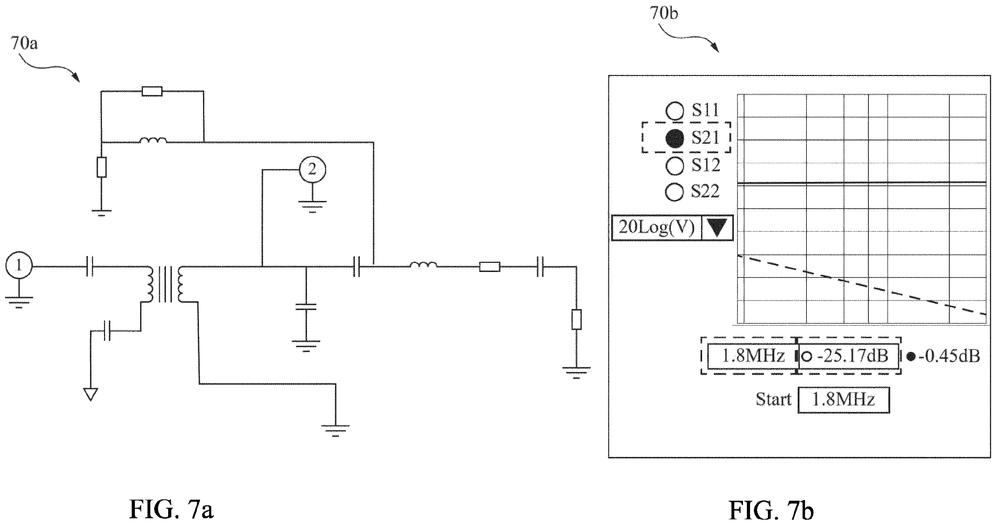

For example, an insertion loss of the communication wires (e.g., CP and PE) of a coupler loop can be obtained via a transceiver bidirectional channel (e.g., CH57). FIGs. 6a and 6b show an equivalent circuit example 60a and an insertion loss curve example 60b for a charging station, respectively. The insertion loss curve example 60b shows an insertion loss (S21) of the equivalent circuit example 60a in the frequency band of 150 kHz to 30 MHz, approximately -20.49 dB. FIGs. 7a and 7b show an equivalent circuit example 70a and an insertion loss curve example 70b for another charging station. The insertion loss curve example 70b shows an insertion loss (S21) of the equivalent circuit example 70a in the frequency band of 150 kHz to 30 MHz, approximately -25.17 dB, wherein the insertion losses of the two charging stations shown in FIGS. 6b and 7b differ by about 5 dB.

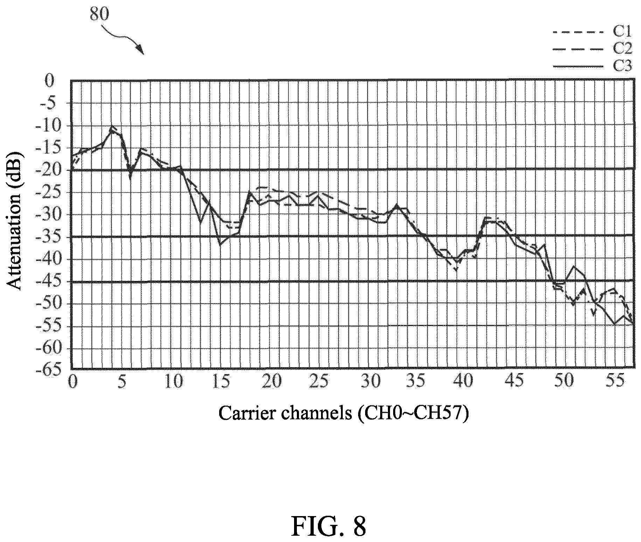

FIG. 8 shows a signal strength curve example 80 of multiple signal channels (such as carrier channels CH0 to CH57) obtained from several charging stations, wherein three curves, C1, C2, and C3, show a trend in which the signal strength attenuates as the frequency of the carrier channel (CHx, x = 0 to 57) increases, wherein the signal strengths of about two-thirds of the channels are lower than -31 dB, and the distribution profile of the received signal strength (such as CH57) of the communication wire (such as CP) of the coupler loop has a value of about -60 dB to -66 dB (lower than the range of -20 dB to -39 dB).

The above content shows that the charging station and the electric vehicle communicate via two communication wires (such as CP and PE) during the charging communication operation. If the impedance between the charging station and the electric vehicle is mismatched, signal attenuation during the communication process will occur, resulting in the inability to complete the communication operation and further leading to charging abnormalities.

For example, herein, power line communication (PLC) is an example of a charging communication technology, e.g., based on ISO-15118-3/IEC-61851-1 specifications. Two communication wires can be used in the charging station: a control pilot wire (CP) and a protective ground wire (PE). The two wires have capacitance characteristics, which is a key factor affecting the charging communication operation. The reason lies, at least, in the fact that charging stations need to supply power to electric vehicles of different brands, and the impedance states of various electric vehicles are not the same.

Therefore, to avoid impedance mismatches between the charging station and the electric vehicle, the charging station needs communication impedance tuning capability to match electric vehicles with different impedance states. When the charging station and the electric vehicle are coupled to form a coupler, the impedance of the charging station and the electric vehicle on both sides of the coupler tends to match to prevent severe signal attenuation caused by impedance mismatches, facilitating the completion of the charging communication process.

As described above, the present invention proposes an implementation. For example, during the charging communication operation, the charging station and the electric vehicle communicate via two communication wires (such as CP and PE). A control method for the coupler formed by the communication wires (such as CP and PE) operating in an open-loop state can adopt an impedance tuning control scheme for the communication wires (such as CP and PE). Examples are provided below but are not intended to be limited.

For example, based on the characteristics of the communication wires, a communication-wire-impedance tuning method can be used to tune the reactance characteristics (including inductive reactance and capacitive reactance) of the communication wires. When the charging station and the electric vehicle form a coupler connection state and enter a data transmission mode, the signal strengths of the communication wires (such as CP and PE) are obtained by a specific method (such as sweeping a specific channel or executing a specific command by a controller). For example, the controller of the charging station sends a "CM_ATTEN_CHAR.IND" command to receive the "ATTEN _PROFILE" content as the information of a signal attenuation distribution profile. In this way, the signal characteristics of the communication wires can be quickly obtained.

Accordingly, the present invention provides a control scheme with self-tuning impedance to facilitate a data transmission mode (or diagnostic regulation procedures). The coupler formed between the charging station and the electric vehicle enables a closed-loop detection function for communication wires (such as CP and PE) with impedance regulation capability. As a result, data transmission quality is improved, preventing signal attenuation during communication, which could lead to communication failures and charging abnormalities.

In one embodiment, after the relevant data is collected, it can also be used to understand the impedance matching information of the communication wires (such as CP and PE) of different electric vehicles. This information can then be used to evaluate the characteristics of the communication wires suitable for different vehicles and formulate charging impedance tuning plans suitable for different vehicles, improving charging compatibility and adaptability and further achieving the technical effect of optimizing the vehicle charging process.

The present invention proposes an implementation(s) based on the above scheme, and examples are illustrated but are not limited thereto.

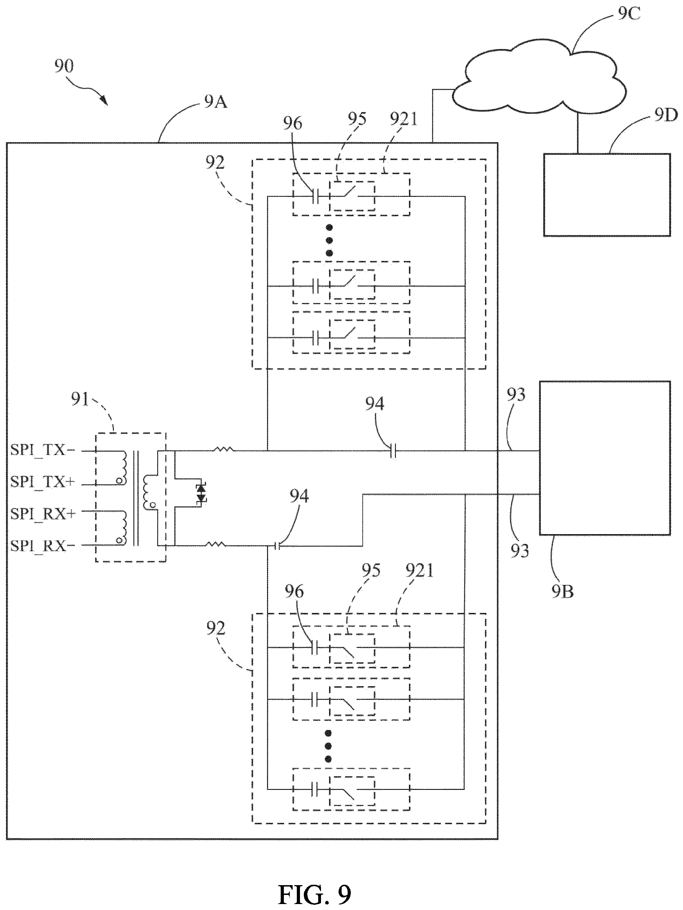

In an aspect, as shown in FIG. 9, an embodiment of the present invention provides a vehicle charging device. For example, in a vehicle charging system 90 (such as a CCS), a vehicle charging device 9A is coupled to an electric vehicle 9B. The vehicle charging device 9A can be configured to form a charging station for a vehicle (such as a motorcycle or a car). The vehicle charging device 9A includes a transformer 91 and a two-impedance tuner 92.

For example, as shown in FIG. 9, the transformer 91 has a first side and a second side. The first side of the transformer 91 can transmit a signal from an electronic device via signal wires (e.g., a transmission signal wire (such as SPI_TX+ and SPI_TX-) and a receiving signal wire (such as SPI_RX+ and SPI_RX-) of a serial peripheral interface (SPI). The first side of the transformer 91 can receive signals from a controller (such as a power line communication chipset (PLC chipset), referring to 211 in FIG. 2 and 511 in FIG. 5). The controller can collect signal strengths of multiple signal channels as a basis for communication and control. The second side of the transformer 91 is provided with two communication wires 93 to couple the electric vehicle 9B.

For example, as shown in FIG. 9, each of the two impedance tuners 92 is connected in parallel to one of the two communication wires 93, and the two impedance tuners 92 are configured to regulate the reactance characteristics of the two communication wires 93. For example, each impedance tuner 92 may include at least one branch path 921 to regulate the reactance characteristics of the communication wire 93, as illustrated below.

For example, as shown in FIG. 9, each communication wire 93 has a first capacitor 94, each impedance tuner 92 includes at least one branch path 921, and the branch path 921 is connected in parallel to the first capacitor 94. For example, each branch path 921 includes a switch 95 and a second capacitor 96, wherein the switch 95 is connected in series to the second capacitor 96. The switch 95 of each branch path 921 can be configured to form a parallel loop or an open circuit with the first capacitor 94 and the second capacitor 96 according to a control signal from a controller (such as a PLC chipset) to gradually regulate (such as increase or decrease) the number of second capacitors 96 connected in parallel with the first capacitor 94 to control a value of an equivalent capacitance of the communication wire 93, such as from 10nF to 20nF, but not limited to the description here.

As shown in FIG. 9, if the number of switches 95 of the branch path 921 that are configured to be turned on (Turn ON) is larger, the number of second capacitors 96 that form a parallel circuit with the first capacitor 94 is larger, such that the value of the equivalent capacitance of the communication wire 93 is larger, and the equivalent capacitive reactance (ZC) of the communication wire 93 is higher; if the number of switches 95 of the branch path 921 that are configured to be turned on (Turn ON) is smaller, the number of second capacitors 96 that form a parallel circuit with the first capacitor 94 is smaller, such that the value of the equivalent capacitance of the communication wire 93 is smaller, and the equivalent capacitive reactance (ZC) of the communication wire 93 is lower. Therefore, the vehicle charging device 9A can control the number of second capacitors 96, forming a parallel circuit with the first capacitor 94, by using the switch 95 of each branch path 921 to regulate the reactance characteristics of the communication wire 93 in response to the signal strength of the communication wire 93.

In the process of regulating the signal strength of a communication wire, considering that the signal frequency of the communication wire is relatively high (e.g., within the band between 150 kHz and 30 MHz), the selection of the switch must take the signal frequency of the communication wire into account to regulate the impedance state of the communication wire in response to the signal strength of the communication wire real-time. Herein, an impedance tuner, including a branch path, is taken as an example for illustration but not limited thereto.

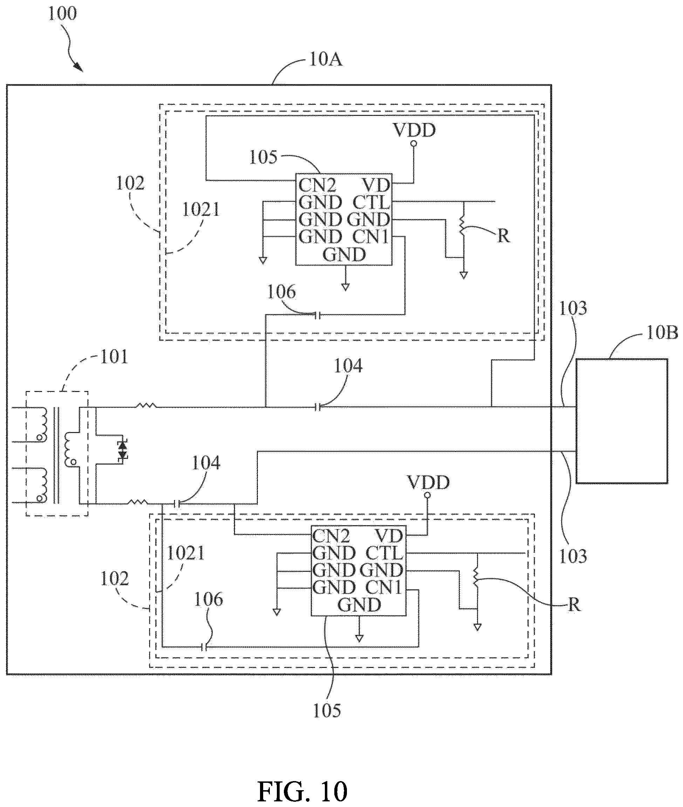

As shown in FIG. 10, the vehicle charging system 100 includes a vehicle charging device 10A and an electric vehicle 10B. The vehicle charging device 10A includes a transformer 101 and two impedance tuners 102. Each of the two impedance tuners 102 is connected to one of the two communication wires 103 in parallel. Each communication wire 103 has a first capacitor 104. Each impedance tuner 102 includes at least one branch path 1021 (only one branch path 1021 is shown in FIG. 10). For example, each branch path 1021 includes a switch 105 and a second capacitor 106. The switch 105 may be a high-frequency switching element. Its operating frequency range includes 150 kHz to 30 MHz but is not limited to that range.

To ensure the switching speed of switches and avoid the signal from interfering with switches, as shown in FIG. 10, the switch 105 may be a chip-type switch. For example, the chip-type switch has a control terminal CTL and two connection terminals CN1, and CN2, the second capacitor 106 is connected between one of the two connection terminals CN1, CN2 (such as CN1) and one end of the first capacitor 104, and the other of the two connection terminals CN1, CN2 (such as CN2) is connected to the other end of the first capacitor 104. In addition, as shown in FIG. 10, the switch 105 may also involve other configurations, such as a power supply terminal VD (used for an external DC power supply VDD) and a plurality of ground terminals GND (used for electrical grounding), a resistor R may be provided between the control terminal CTL and the ground terminal GND, such that the control terminal CTL can maintain a suitable control voltage difference to control the switching state between the two connection terminals CN1, CN2 to be turned on (ON) or off (OFF).

Please refer to FIG. 9 again. The vehicle charging device 9A can also be coupled to a cloud computation platform 9D via a network 9C. For example, a plug of a charging gun provided by the vehicle charging device 9A can be inserted into a socket from the electric vehicle 9B. When the vehicle charging device 9A and the electric vehicle 9B form the state of a coupler, the vehicle charging device 9A can not only collect signal strength information as a basis for whether the communication wire impedance needs to be regulated but also collect vehicle-related information (such as brand or model). The information collected by the vehicle charging device 9A can be aggregated to the cloud computation platform 9D via the network 9C for operations such as big data analysis to find impedance matching schemes suitable for the charging communication process of different vehicles. For similar vehicles in the future, the vehicle charging device 9A can also refer to a recommended impedance matching scheme (e.g., provided by the cloud computation platform) to regulate the impedance matching state of the communication wire to smoothly complete the charging communication operation and carry out the subsequent charging mode.

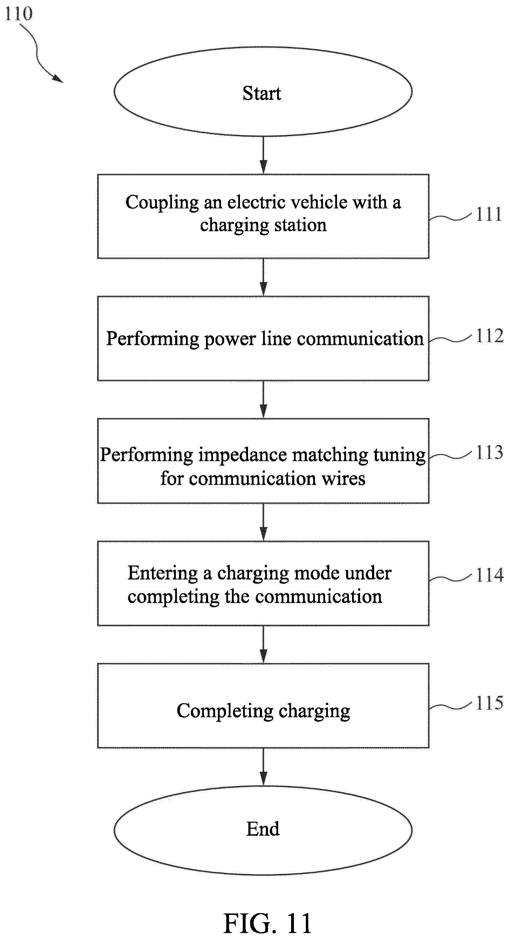

In another aspect, as shown in FIG. 11, an embodiment of the present invention provides a vehicle charging method example 110, which can be applied to the above-mentioned vehicle charging device (e.g., vehicle charging device 9A, as shown in FIG. 9, can be configured as an electric vehicle charging station). The method example 110 includes steps 111 to 115. Examples are provided as the following but are not intended to be limited.

As shown in FIG. 11, in step 111, coupling an electric vehicle with a charging station. For example, the vehicle charging device 9A, as shown in FIG. 9, detects that two communication wires 93 connected to the vehicle charging device 9A are coupled to the electric vehicle 9B. Subsequently, proceeding to step 112.

As shown in FIG. 11, in step 112, performing a power line communication operation. For example, the vehicle charging device 9A, as shown in FIG. 9, performs power line communication (PLC) with the electric vehicle 9B, such that the vehicle charging device 9A collects the signal strength of several signal channels for the electric vehicle 9B. Subsequently, proceeding to step 113.

As shown in FIG. 11, step 113, performing impedance matching tuning for communication wires. For example, the vehicle charging device 9A, as shown in FIG. 9, monitors communication characteristics of two communication wires 93 according to the signal strength of the plurality of signal channels to cause the signal strength of the two communication wires 93 to meet a strength requirement. For example, the vehicle charging device 9A, as shown in FIG. 9, performs a calculation for a signal strength mean based on the signal strength of the plurality of signal channels, e.g., the signal strength mean is equal to a quotient of a sum of the plurality of signal strengths and the number of signal strengths. In addition, the vehicle charging device 9A confirms that the signal strength of the two communication wires 93 meets the strength requirement based on the signal strength mean and a signal strength threshold (e.g., -31 dB, but not limited to this value). For example, a controller of the vehicle charging device 9A performs a determination of whether the mean signal strength is less than the signal strength threshold. If the determination is positive (YES), the controller of the vehicle charging device 9A gradually regulates the impedance of the two communication wires 93. For example, the vehicle charging device 9A causes a value of an equivalent capacitance of the two communication wires 93 to be increased by a predetermined amount (e.g., by increasing the number of parallel capacitors) to bring the impedance of both the vehicle charging device 9A and the electric vehicle 9B trend to be matched, thereby increasing the signal strength mean. Then, the above steps for the calculation and determination are repeated. If the determination is negative (NO), the controller of the vehicle charging device 9A confirms that the signal strength of the two communication wires 93 meets the strength requirement. Subsequently, proceeding to step 114.

As shown in FIG. 11, step 114, entering a charging mode under completing the communication. For example, as shown in FIG. 9, in response to the signal strength of the two communication wires 93 meet the strength requirement, the vehicle charging device 9A performs the charging mode for the electric vehicle 9B. For example, the vehicle charging device 9A can also collect characteristic information of the electric vehicle 9B (such as the signal strength of the communication wires 93, impedance characteristics, and the vehicle model) before or during the charging process and then transmit the characteristic information to the cloud computation platform 9D. The cloud computation platform 9D can generate a charging plan for the vehicle charging device 9A based on the characteristic information, and the vehicle charging device 9A can charge the electric vehicle 9B according to the charging plan. In this way, charging solutions can be provided quickly and appropriately using the content of big data, reducing the occurrence of charging abnormalities.

As shown in FIG. 11, the vehicle charging method 110 includes step 115, completing charging. For example, as shown in FIG. 9, the electric vehicle 9B can feed power information back to the vehicle charging device 9A in the charging mode. If the vehicle charging device 9A detects that the battery power of the electric vehicle 9B is greater than or equal to a power threshold, the charging mode can be terminated. For example, the vehicle charging device 9A can output charging completion information, such as displaying a screen, generating a sound effect, or sending a text message so that users can know that the electric vehicle 9B is in a charging completion state.

In summary, in the vehicle charging device and method of the present invention, the second side of the transformer of the vehicle charging device is provided with two communication wires (having capacitors) to couple the electric vehicle, each impedance tuner of the vehicle charging device is connected in parallel to one communication wire. The two impedance tuners are configured to regulate the reactance characteristics of the two communication wires. For example, each of the two impedance tuners includes at least one branch path (including a switch and a capacitor), and each of at least one branch path is connected in parallel with the capacitor of the communication wire. Thus, in response to the signal strength of the communication wire, an appropriate number of capacitors in branch paths can be gradually controlled to connect to the capacitors of the communication wires to regulate the impedance of the communication wires such that the vehicle charging device and the electric vehicle to communicate with each other in a state approaching impedance matching, thereby avoiding abnormal situations such as the electric vehicle being unable to charge or charging being interrupted due to excessively high bit error rates in data exchange.

Although the present invention has been disclosed in terms of preferred embodiments, anyone skilled in the art may make various changes and modifications without departing from the concept and scope of the present invention. Therefore, the scope of protection of the present invention shall be determined by the claims.

## Claims

1. A vehicle charging device, comprising:
a transformer having a first side and a second side, the second side being provided with two communication wires to couple with an electric vehicle; and
two impedance tuners, each of the two impedance tuners being connected in parallel to one of the two communication wires, and the two impedance tuners being configured to regulate reactance characteristics of the two communication wires.

2. The vehicle charging device as claimed in claim 1, wherein each of the two communication wires has a first capacitor, each of the two impedance tuners comprises at least one branch path, and each of the at least one branch path and the first capacitor are connected in parallel.

3. The vehicle charging device as claimed in claim 2, wherein each of the at least one branch path comprises a switch and a second capacitor, and the switch and the second capacitor are connected in series.

4. The vehicle charging device as claimed in claim 3, wherein the switch is configured to make the first capacitor and the second capacitor form either a parallel circuit or an open circuit based on a control signal from a controller.

5. The vehicle charging device as claimed in claim 3, wherein the switch is a high-frequency switching element.

6. The vehicle charging device as claimed in claim 5, wherein an operating frequency range of the high-frequency switching element comprises 150 kHz to 30 MHz.

7. The vehicle charging device as claimed in claim 5, wherein the high-frequency switching element is a chip-type switch and has a control terminal and two connection terminals, the second capacitor is connected between one of the two connection terminals and one end of the first capacitor, and the other of the two connection terminals is connected to the other end of the first capacitor.

8. The vehicle charging device as claimed in claim 1, wherein the two communication wires comprise a control pilot wire and a protective earth wire.

9. The vehicle charging device as claimed in claim 1, wherein the vehicle charging device is coupled to a cloud computation platform via a network.

10. A vehicle charging method applied to a vehicle charging device, the vehicle charging device comprising a transformer and two impedance tuners, the transformer having a first side and a second side, the second side being provided with two communication wires to couple with an electric vehicle, each of the two impedance tuners being connected in parallel to one of the two communication wires, the two impedance tuners being configured to regulate reactance characteristics of the two communication wires, and the method comprising:
detecting the electric vehicle being coupled to two communication wires connected to the vehicle charging device;
performing power line communication between the vehicle charging device and the electric vehicle to enable the vehicle charging device to collect signal strengths of a plurality of signal channels for the electric vehicle;
monitoring, by the vehicle charging device, the communication characteristics of the two communication wires based on the signal strengths of the plurality of signal channels to enable signal strengths of the two communication wires to meet a strength requirement; and
in response to the signal strengths of the two communication wires meet the strength requirement, performing a charging mode for the electric vehicle.

11. The vehicle charging method as claimed in claim 10, wherein the monitoring, by the vehicle charging device, the communication characteristics of the two communication wires based on the signal strengths of the plurality of signal channels to enable signal strengths of the two communication wires to meet the strength requirement, comprising:
calculating, by the vehicle charging device, a signal strength mean based on the signal strengths of the plurality of signal channels; and
confirming, by the vehicle charging device, the signal strengths of the two communication wires meet the strength requirement based on the signal strength mean and a signal strength threshold.

12. The vehicle charging method as claimed in claim 11, wherein the confirming, by the vehicle charging device, the signal strengths of the two communication wires meet the strength requirement based on the signal strength mean and the signal strength threshold, comprising:
determining, by the vehicle charging device, whether the signal strength mean is less than the signal strength threshold, if a determination is positive, the vehicle charging device causes a value of an equivalent capacitance of the two communication wires to be increased by a predetermined amount, and re-performing the calculating and the determining, if the determination is negative, the vehicle charging device confirms the signal strength of the two communication wires meet the strength requirement.

13. The vehicle charging method as claimed in claim 11, wherein the signal strength threshold is -31 dB.

14. The vehicle charging method as claimed in claim 10, wherein the vehicle charging device is coupled to a cloud computation platform through a network, and the method further comprises:
collecting characteristic information of the electric vehicle and transmitting the characteristic information to the cloud computation platform, by the vehicle charging device; generating, by the cloud computation platform, a charging plan for the vehicle charging device based on the characteristic information; and
charging, by the vehicle charging device, the electric vehicle based on the charging plan.

15. The vehicle charging method as claimed in claim 10, wherein each of the two communication wires has a first capacitor, each of the two impedance tuners comprises at least one branch path, and each of the at least one branch path and the first capacitor are connected in parallel.

16. The vehicle charging method as claimed in claim 15, wherein each of the at least one branch path comprises a switch and a second capacitor, and the switch and the second capacitor are connected in series.

17. The vehicle charging method as claimed in claim 16, wherein the switch is configured to make the first capacitor and the second capacitor form either a parallel circuit or an open circuit based on a control signal from a controller.

18. The vehicle charging method as claimed in claim 16, wherein the switch is a high-frequency switching element.

19. The vehicle charging method as claimed in claim 18, wherein an operating frequency range of the high-frequency switching element comprises 150 kHz to 30 MHz.

20. The vehicle charging method as claimed in claim 18, wherein the high-frequency switching element is a chip-type switch and has a control terminal and two connection terminals, the second capacitor is connected between one of the two connection terminals and one end of the first capacitor, and the other of the two connection terminals is connected to the other end of the first capacitor.
